(19) Europäisches Patentamt / European Patent Office / Office européen des brevets

(11) **EP 2 792 482 A1**

(12) **EUROPEAN PATENT APPLICATION**
published in accordance with Art. 153(4) EPC

(43) Date of publication:
**22.10.2014 Bulletin 2014/43**

(51) Int Cl.:
**B32B 9/00** *(2006.01)*    **B32B 27/00** *(2006.01)*
**B32B 27/16** *(2006.01)*

(21) Application number: **12858332.5**

(22) Date of filing: **10.12.2012**

(86) International application number:
**PCT/JP2012/081874**

(87) International publication number:
**WO 2013/089046 (20.06.2013 Gazette 2013/25)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **16.12.2011   JP 2011275493**

(71) Applicant: **Konica Minolta, Inc.**
**Tokyo 100-7015 (JP)**

(72) Inventor: **NISHIO, Shoji**
**Tokyo 100-7015 (JP)**

(74) Representative: **Henkel, Breuer & Partner**
**Patentanwälte**
**Maximiliansplatz 21**
**80333 München (DE)**

(54) **GAS BARRIER FILM**

(57)   A gas barrier film (10) which is provided with: a gas barrier layer (2) that has been irradiated with vacuum ultraviolet light and is laminated on a base (1); and a protective layer (3). The gas barrier film (10) is configured so that the gas barrier layer (2) satisfies such requirements that: at least a part of the gas barrier layer (2) has an $SiO_xN_y$ composition wherein the condition $0.1 \leq x/(x+y) \leq 0.9$ is satisfied; and the ratio of the film density of the protective layer (3) to the film density of the gas barrier layer (2) is from 0.2 to 0.75 (inclusive).

**Description**

TECHNICAL FIELD

The present invention relates to a gas barrier film.

BACKGROUND ART

Gas barrier films composed of thin films (gas barrier layers) of metal oxides, such as aluminum oxide, magnesium oxide, and silicon oxide, formed on surfaces of plastic substrates or film substrates, have been widely used for wrapping of products that should be protected from gas attacks, such as water vapor and oxygen, more specifically for wrapping of foods, industrial products, and pharmaceuticals to prevent alterations in their properties. In addition to such wrapping of products, gas barrier films are used for sealing electronic devices, such as photovoltaic cells, liquid crystal display elements, and organic EL elements, to prevent alterations due to various gases.

In addition to demands for larger and lighter electronic apparatuses, such as liquid display panels, there have recently been demands that apparatuses have long-term reliability and high flexible in shape (for example, a demand that the apparatuses have a curved display surface). To meet such demands, film substrates composed of transparent plastic have been used instead of glass substrates, which are heavy, fragile, and unsuitable for use on large areas.

Unfortunately, film substrates composed of transparent plastic have inferior gas barrier properties compared to glass substrates. For example, a liquid crystal display panel including a substrate having inferior gas barrier properties may have display defects caused by degraded liquid crystal in the liquid crystal cell due to the permeation of water vapor and air, and thus may have low display qualities. In light of this, gas barrier films formed by disposing gas barrier layers on film substrates have been used as effective material.

A known gas barrier film for wrapping and device sealing has a gas barrier layer of silicon oxide or aluminum oxide deposited on a plastic film. Unfortunately, the water vapor transmission rate (water vapor barrier characteristic) of a gas barrier film having a deposited gas barrier layer is approximately 1 $g/m^2/day$, which is inferior to 0.1 $g/m^2/day$, which is a current required level.

A gas barrier layer may be formed by a known process, other than deposition, such as silica conversion of a coating film of perhydropolysilazane (also referred to as PHPS) or organic polysilazane. Silica conversion can be established through heating and humidification or through sintering. Such processes, however, require a long time for the formation of a gas barrier layer and cause the degradation of the substrate due to exposure to high temperatures.

A simpler process that does not cause degradation of the substrate has been in need for the formation of a gas barrier film having superior water vapor barrier characteristic.

For example, Patent Literature 1 discloses a technique for forming a transparent polymer layer over a gas barrier layer to improve the gas barrier properties.

Patent Literature 2 discloses a technique associated with the formation of polymer multilayers (PML). With this technique, a barrier film is formed by coating a flexible substrate with a polymer layer and an aluminum oxide layer. The permeability of water and oxygen of the resulting barrier film is significantly reduced compared to an uncoated PET film.

Patent Literature 3 discloses a technique involving applying a coating solution containing PHPS or organic polysilazane to a polyester film, and curing or polymerizing the PHPS or organic polysilazane through plasma treatment, to form a silicon oxide inorganic polymer layer. The inorganic polymer layer, which is an intermediate layer disposed between the substrate and a metal deposition layer, improves the adhesiveness of the metal deposition layer and the substrate and the chemical stability of the substrate.

Patent Literature 4 discloses a process of manufacturing a thin protective layer of a magnetic strip and a method of modifying a polysilazane layer with ozone, oxygen atoms, or vacuum ultraviolet rays in oxygen or water vapor. Such a process reduces the time required for the modification treatment at room temperature to several minutes. The vacuum ultraviolet rays in the process are used merely for the generation of reactive species. Patent Literature 4 states that heating to an allowable temperature limit of a substrate (for example, 180°C for polyethylene terephthalate) during the modification treatment converts and modifies a polysilazane layer having a thickness of approximately 20 nm in several seconds to several minutes.

PRIOR ART LITERATURES

PATENT LITERATURES

Patent Literature 1: Japanese Patent Application Laid-Open Publication No. 6-234186

Patent Literature 2: US Patent No. 5,260,095
Patent Literature 3: Japanese Patent Application Laid-Open Publication No. 8-269690
Patent Literature 4: EP Patent No. 0,745,974

DISCLOSURE OF INVENTION

PROBLEMS TO BE SOLVED BY THE INVENTION

Conventional gas barrier films have unsatisfactory gas barrier properties, transparency, and flexibility.

An object of the present invention, which has been conceived in light of the issues described above, is to provide a gas barrier film having excellent gas barrier properties, transparency, and flexibility.

MEANS FOR SOLVING PROBLEMS

In order to achieve the object, the invention recited in Claim 1 is a gas barrier film including at least one gas barrier layer and a protective layer over a substrate, the protective layer containing organosilicon and being disposed on the gas barrier layer, wherein at least part of the gas barrier layer has a composition $SiO_xN_y$ where a condition $0.1 \leq x/(x+y) \leq 0.9$ is satisfied, the protective layer has received a modification treatment, which is irradiation with ultraviolet light having a wavelength of 300 nm or less, and a ratio of a density of the protective layer to a density of the gas barrier layer is 0.2 or more and 0.75 or less.

The invention recited in Claim 2 is the gas barrier film according to Claim 1, wherein the substrate has a thermal expansion rate of 100 ppm/°C or less and a glass-transition temperature of 120°C or more.

The invention recited in Claim 3 is the gas barrier film according to Claim 1 or 2, wherein the gas barrier layer is formed by performing a modification treatment to a coating film containing polysilazane, the modification treatment being irradiation with ultraviolet light having a wavelength of 400 nm or less.

The invention recited in Claim 4 is the gas barrier film according to any one of Claims 1 to 3, wherein the protective layer comprises material containing a siloxane bond.

The invention recited in Claim 5 is the gas barrier film according to any one of Claims 1 to 4, wherein, on each side of one of the gas barrier layer and the protective layer, the other of the gas barrier layer and the protective layer is disposed.

The invention recited in Claim 6 is the gas barrier film according to any one of Claims 1 to 5, wherein the modification treatment is irradiation with vacuum ultraviolet light having a wavelength of less than 180 nm.

EFFECTS OF THE INVENTION

The present invention provides a gas barrier film having excellent gas barrier properties, transparency, and flexibility. BRIEF DESCRIPTION OF DRAWINGS

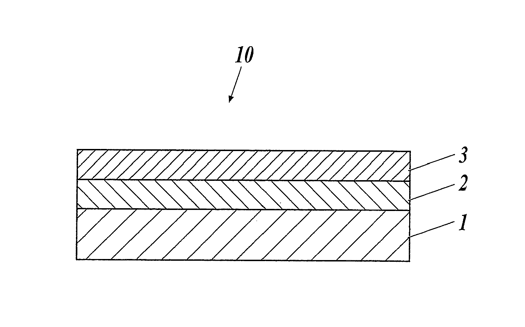

FIG. 1 is an explanatory view showing an example gas barrier film according to the present invention.

EMBODIMENT FOR CARRYING OUT THE INVENTION

Preferred embodiments to carry out the present invention will now be described with reference to the drawing. The following embodiments involve various technically preferred limitations for accomplishing the present invention. The scope of the invention, however, should not be limited to the embodiments and the drawing.

A gas barrier film 10 according to the present invention includes a predetermined substrate 1, at least one gas barrier layer 2 disposed over the substrate 1, and a protective layer 3 adjoining the gas barrier layer 2.

The inventor, who has conducted an extensive investigation, has found that a gas barrier film 10 having superior gas barrier properties is obtained by disposing, over at least one side of a substrate 1, a gas barrier layer 2 containing $SiO_xN_y$ and an organosilicon protective layer 3 adjoining the gas barrier layer 2, and appropriately adjusting the film densities of the gas barrier layer 2 and the protective layer 3.

Specifically, at least part of the gas barrier layer 2 of the gas barrier film 10 according to the present invention has a composition $SiO_xN_y$ where the condition $0.1 \leq x/(x+y) \leq 0.9$ is satisfied, and the protective layer 3 has received a modification treatment in which irradiation with ultraviolet rays having a wavelength of 300 nm or less is performed. In a gas barrier film 10 according to a preferred embodiment of the present invention, the ratio of the density of the protective layer 3 to the density of the gas barrier layer 2 is 0.2 or more and 0.75 or less.

In a preferred layer configuration, on both sides of one of the gas barrier layer 2 and the protective layer 3, the other of the layers 2 and 3 is disposed (specifically, the layer configuration where a gas barrier layer 2, a protective layer 3, and a gas barrier layer 2 are disposed in sequence; or a protective layer 3 , a gas barrier layer 2 , and a protective layer 3 are disposed in sequence). The gas barrier layer 2 is more preferably covered with the protective layer 3 (i.e., the protective layer 3 is disposed on the gas barrier layer 2).

A known primer layer, smooth layer, or anchor coat layer may be disposed on the surface of the substrate to serve as an intermediate layer for the enhancement of the smoothness of the substrate 1 and the adhesiveness of the gas barrier layer 2 and the protective layer 3 to the substrate 1.

The surface of the substrate 1 may have a scratch resistance layer for the prevention of scratching and contamination of the substrate 1 and/or a bleed preventing layer for the prevention of so-called bleeding, which is the deposition of components having a low molecular weight, such as monomers and oligomers, from inside of the substrate 1 to its surface due to heating.

The configuration of a gas barrier film according to the present invention will now be described in detail.

(Substrate)

A substrate constituting a gas barrier film according to the present invention and serving as a support of the gas barrier film is preferably a flexible and bendable film substrate having heat resistance to continuous use at 150°C or higher.

Specifically, the substrate of the gas barrier film according to the present invention is preferably a film substrate having a low thermal expansion rate (small coefficient of thermal expansion) of 100 ppm/°C or less. More preferably, the expansion rate is 50 ppm/°C or less. A substrate having a thermal expansion rate exceeding 100 ppm/°C is not preferred because of the ready deformation of the substrate (gas barrier film) due to heat. The thermal expansion rate is determined by preparing a sample film substrate heated at 80°C for 10 minutes and then dried, measuring the sample with a thermomechanical analyzer, and determining the change in dimension of the sample between the temperatures of 50°C and 150°C.

The substrate of the gas barrier film according to the present invention preferably has a predetermined coefficient of thermal expansion and/or a predetermined coefficient of hygroscopic expansion and has a glass-transition temperature (glass transition point Tg) of 150°C or higher. A substrate having a glass-transition temperature lower than 150°C is not preferred because of the ready softening of the substrate due to heat generated during the formation of thin films (for example, a gas barrier layer and a protective layer) over the substrate, and the resulting deformation and modification of the substrate. A high glass-transition temperature is preferred to prevent thermal deformation of the substrate. The glass-transition temperature of the substrate described below is 300°C or lower. A substrate having a glass-transition temperature exceeding 300°C is less flexible and is difficult to continuously process.

Examples of synthetic resin used to compose the substrate include crystalline resins, such as polyamides, polyacetals, polybutylene terephthalate, polyethylene terephthalate, polyethylene naphthalate, and syndiotactic polystyrene, which are thermoplastic resins. Examples of thermosetting resins include polyphenylene sulfide, polyether ether ketones, liquid crystal polymers, fluorine resins, and polyether nitrile.

Examples of synthetic resins used to compose the substrate include amorphous resins, such as polycarbonates, modified-polyphenylene ethers, polycyclohexene, and polynorbornene resins, which are thermoplastic resins. Examples of thermosetting resins include polysulfones, polyethersulfones, polyarylates, polyamideimides, polyetherimides, and thermoplastic polyimides. In particular, polycarbonates, which have a low absorptivity, are preferred for the formation of a substrate having a small coefficient of hygroscopic expansion.

The thermal properties or, specifically, the response to external forces required for a substrate can be defined by the deflection temperature under load, which is a more practical index. The substrate preferably has a deflection temperature under load of 150°C or higher. The deflection temperature under load of polycarbonate resin is 160°C; the deflection temperature under load of polyarylate resin is 175°C; the deflection temperature under load of polyether sulfone resin is 210°C; the deflection temperature under load of cycloolefin polymers ("Zeonor" manufactured by Zeon Co.) is 150°C; and the deflection temperature under load of norbornene resin ("Arton" manufactured by JSR Co.) is 155°C.

The thermal properties required for a substrate may be defined by the maximum temperature of continuous use. The maximum temperature of continuous use of the substrate is preferably 150°C or higher. The deflection temperature under load is identical to the maximum temperature of continuous use of each resin listed above.

The substrate provided at the display screen of a display apparatus is preferably light-transmissive or transparent to achieve excellent visibility of images. The thickness of the substrate is approximately 1 to 400 $\mu$m and may be appropriately selected depending on the use.

A substrate having a smooth surface is preferred to provide a final product, such as a display apparatus, having a sufficiently smooth-looking surface and to form even thin films (gas barrier layer and protective layer) over the substrate. The surface of the substrate is preferably as smooth as having an average roughness (Ra) of 2 nm or less. The lower limit is not defined; however, the average roughness is 0.01 nm or more in terms of practical use. The smoothness of both sides of the substrate or at least one side, over which thin films (gas barrier layer and protective layer) are to be provided, of the substrate may be enhanced through polishing, if necessary.

Both sides of the substrate or at least the side, over which thin films (gas barrier layer and protective layer) are to be provided, of the substrate may be processed, if necessary, to enhance the adhesiveness of the thin films through various known treatments, such as corona discharge treatment, flame treatment, oxidation, plasma treatment, or the formation of a primer layer on the surface of the substrate. Such treatments may be combined.

(Gas Barrier Layer)

At least part of the gas barrier layer has a composition $SiO_xN_y$ where the condition $0.1 \leq x/(x+y) \leq 0.9$ is satisfied.

For example, the gas barrier layer may have a double layer configuration composed of a silicon oxynitride sublayer having a composition $SiO_xN_y$ and an organic intermediate sublayer. The silicon oxynitride sublayer is composed of silicon, oxygen, and nitrogen as primary components. The organic intermediate sublayer contains carbon atoms. The organic intermediate sublayer preferably comprises a silicon oxide organic film composed of carbon, hydrogen, oxygen, and silicon as primary components. The term primary components indicate that the total amount of silicon, oxygen, and nitrogen elements in the silicon oxynitride sublayer and the total amount of silicon, oxygen, and carbon elements in the silicon oxide organic film (organic intermediate sublayer) are 90 mass% or more, more preferably 95 mass% or more, and most preferably 98 mass% or more of the entire elements in each of the entire sublayers.

($SiO_xN_y$: Silicon Oxynitride Sublayer)

The main constituents of the silicon oxynitride sublayer ($SiO_xN_y$) in the gas barrier layer are silicon, oxygen, and nitrogen. Elements, such as hydrogen and carbon, other than the main constituents contained in the gas barrier layer are each preferably less than 5%.

The composition ratio of oxygen and nitrogen ($x/(x+y)$) in the composition $SiO_xN_y$ of the gas barrier layer is in the range of $0.1 \leq x/(x+y) \leq 0.9$.

The composition ratio is preferably in the range of $0.2 \leq x/y \leq 5.0$. If x/y is 5.0 or less, superior gas barrier properties are readily achieved. If x/y is 0.2 or more, the adhesiveness of the silicon oxynitride sublayer and the organic intermediate sublayer is enhanced and separation is less likely to occur. Thus, such a barrier film is suitable for reeling and bending. The value of x/y is more preferably within the range of 0.33 to 2.0 (inclusive), most preferably within the range of 0.5 to 1.0 (inclusive).

The constituent ratio (composition ratio) of the elements of the silicon oxynitride ($SiO_xN_y$) sublayer in the gas barrier layer can be measured by a well-known standard procedure of X-ray photoelectron spectroscopy (XPS) during etching (for example, a procedure using an XPS surface analyzer).

The refractive index of the gas barrier layer (silicon oxynitride sublayer) is preferably within the range of 1.7 to 2.1 (inclusive), more preferably 1.8 to 2.0 (inclusive). The refractive index of 1.9 to 2.0 (inclusive), which achieves a high visible-light transmittance and stable superior gas barrier properties, is the most preferable in particular.

(Formation of Gas Barrier Layer)

The gas barrier layer may be formed through any procedures of forming a target thin film. Examples of suitable procedures include sputtering, vacuum deposition, ion plating, plasma-assisted CVD, and wet coating, such as those described in Japanese Patent No. 3400324 and Japanese Patent Application Laid-Open Publication Nos. 2002-322561 and 2002-361774. The present invention employs the procedures of applying a coating solution containing polysilazane and performing a modification treatment to the coating layer.

(Coating Solution Containing Polysilazane and Coating Film)

According to the present invention, the gas barrier layer disposed over the substrate can be formed by applying a coating solution containing polysilazane to the substrate to form a coating film containing polysilazane and performing a predetermined modification treatment to the coating film.

For example, a coating solution containing polysilazane is prepared by adding polysilazane and an optional catalyst to an organic solvent, and the coating solution containing polysilazane is applied to the substrate through a known wet coating process. The solvent is then removed by evaporation to form a coating film (polysilazane layer) over the substrate. The coating film is subjected to silica conversion through a modification treatment, which is irradiation of the coating film (polysilazane layer) with ultraviolet light having a wavelength of 400 nm or less in air or ozone, to form a gas barrier layer containing $SiO_xN_y$.

The coating solution containing polysilazane can be applied through any appropriate procedure. Specific examples include spin coating, roll coating, flow coating, inkjet printing, spray coating, printing, dip coating, casting, bar coating, and gravure printing.

The thickness of the coating film is appropriately selected in accordance with the use. For example, the coating film preferably has a dry thickness of approximately 10 nm to 10 $\mu$m, more preferably 50 nm to 1 $\mu$m. A coating film having a thickness of 10 nm or more has superior gas barrier properties, whereas a coating film having a thickness of 10 $\mu$m or less can be stably applied during the formation of the polysilazane layer and achieve high light transmittance.

(Polysilazane)

The term "Polysilazane" used in the present invention refers to a polymer that has silicon-nitrogen bonds and is a ceramic precursor inorganic polymer, such as $SiO_2$, $Si_3N_4$, and their intermediate solid solution $SiO_xN_y$ having Si-N, Si-H, and N-H bonds.

The content of the polysilazane in the entire mass (100 mass%) of the gas barrier layer is preferably within the range of 10 to 99 mass% (inclusive), more preferably 40 to 95 mass% (inclusive), and most preferably 70 to 95 mass% (inclusive).

The polysilazane used in the present invention is preferably a compound having a structure represented by the general formula (1):

$$-(SiR^1R^2-NR^3)_n- \qquad (1)$$

where $R^1$, $R^2$, and $R^3$, which are identical to or independent from one another, are groups selected from the group consisting of a hydrogen atom, substituted or unsubstituted alkyl groups, aryl groups, vinyl group, and (trialkoxysilyl)alkyl groups, preferably consisting of a hydrogen atom, a methyl group, an ethyl group, a propyl group, an iso-propyl group, a butyl group, an iso-butyl group, a tert-butyl group, a phenyl group, a vinyl group, a 3-(triethoxysilyl)propyl group, and a 3-(trimethoxysilylpropyl) group; and n represents an integer determined such that the polysilazane having the structure represented by the general formula (1) has a number average molecular weight of 150 to 150,000 g/mol.

The coating solution containing polysilazane and used for the formation of a coating film (polysilazane layer) preferably contains polysilazane and a catalyst. Examples of the preferred catalyst to be applied to the present invention include basic catalysts, specifically N,N-diethylethanolamine, N,N-dimethylethanolamine, triethanolamine, triethylamine, 3-morpholinopropylamine, and N-heterocyclic compounds. Commercially available catalysts may also be used, such as AquamicaNAX120-20, NN110, NN310, NN320, NL110A, NL120A, NL150A, NP110, NP140, and SP140 manufactured by AZ Electronic Materials. The concentration of the catalyst to be added is normally 0.1 to 10 mol%, preferably 0.5 to 7 mol% on the basis of the polysilazane.

In a preferred embodiment, a compound having the structure represented by the general formula (1) is perhydropolysilazane where $R^1$, $R^2$, and $R^3$ are all hydrogen atoms.

The polysilazane of the present invention is preferably a compound having a structure represented by the general formula (2) :

$$-(SiR^1R^2-NR^3)_n-(SiR^4R^5-NR^6)_p- \qquad (2)$$

where each of $R^1$, $R^2$, $R^3$, $R^4$, $R^5$, and $R^6$, independent from one another, represents one of a hydrogen atom, a substituted or unsubstituted alkyl group, aryl group, vinyl group, and (trialkoxysilyl)alkyl group; and n and p represent integers determined such that the polysilazane having the structure represented by the general formula (2) has a number average molecular weight of 150 to 150,000 g/mol.

In the general formula (2), preferably, $R^1$, $R^3$, and $R^6$ each represent a hydrogen atom, and $R^2$, $R^4$, and $R^5$ each represent a methyl group; preferably, $R^1$, $R^3$, and $R^6$ each represent a hydrogen atom, $R^2$ and $R^4$ each represent a methyl group, and $R^5$ represents a vinyl group; or preferably, $R^1$, $R^3$, $R^4$, and $R^6$ each represent a hydrogen atom, and $R^2$ and $R^5$ each represent a methyl group.

The polysilazane of the present invention is preferably a compound having a structure represented by the general formula (3) :

$$- (SiR^1R^2-NR^3)_n-(SiR^4R^5-R^6)_p-(SiR^7R^8-NR^9)_q- \qquad (3)$$

where each of $R^1$, $R^2$, $R^3$, $R^4$, $R^5$, $R^6$, $R^7$, $R^8$, and $R^9$, independent from one another, represents one of a hydrogen atom, a substituted or unsubstituted alkyl group, aryl group, vinyl group, and (trialkoxysilyl)alkyl group; and n, p, and q represent integers determined such that the polysilazane having the structure represented by the general formula (3) has a number average molecular weight of 150 to 150,000 g/mol.

In the general formula (3), preferably, $R^1$, $R^3$, and $R^6$ each represent a hydrogen atom, $R^2$, $R^4$, $R^5$, and $R^8$ each represent a methyl group, $R^9$ represents a (triethoxysilyl) propyl group, and $R^7$ represents an alkyl group or a hydrogen atom.

Organopolysilazane, i.e., polysilazane whose hydrogen atoms bonded with the Si atoms have been partly replaced with, for example, an alkyl group, enhances the adhesiveness to the substrate or primer owing to the presence of the alkyl group, such as methyl group, and provides toughness to a hard and friable ceramic film of polysilazane. This advantageously reduces cracking in the film even if the thickness (average thickness) is increased. Thus, depending on the use, one of perhydropolysilazane and organopolysilazane may be selected, or both of them may be used in combination.

Perhydropolysilazane is presumed to have a linear structure and a cyclic structure of mainly 6- and 8-membered rings. Perhydropolysilazane has a number average molecular weight (Mn) of approximately 600 to 2000 (polystyrene equivalent) and is in the form of liquid or solid depending on the molecular weight. Perhydropolysilazane is commercially available in the form of a solution of perhydropolysilazane dissolved in an organic solvent. A commercial product may be directly used as a coating solution containing polysilazane.

Examples of other polysilazanes that converts to ceramic at low temperatures include silicon-alkoxide-added polysilazane prepared by a reaction of silicon alkoxide with polysilazane having a main skeleton composed of the unit represented by the general formula 1 (for example, refer to Japanese Patent Application Laid-Open Publication No. 5-238827); glycidol-added polysilazane prepared by a reaction of glycidol with polysilazane (for example, refer to Japanese Patent Application Laid-Open Publication No. 6-122852); alcohol-added polysilazane prepared by a reaction of alcohol with polysilazane (for example, refer to Japanese Patent Application Laid-Open Publication No. 6-240208); metal-carboxylate-added polysilazane prepared by a reaction of metal carboxylate with polysilazane (for example, refer to Japanese Patent Application Laid-Open Publication No. 6-299118); acetylacetonate-complex-added polysilazane prepared by a reaction of acetylacetonate complexes including metal with polysilazane (for example, refer to Japanese Patent Application Laid-Open Publication No. 6-306329); and metal-particle-added polysilazane prepared by addition of metal particles to polysilazane (for example, refer to Japanese Patent Application Laid-Open Publication No. 7-196986).

The polysilazane in the coating solution containing polysilazane used for the formation of the coating film (polysilazane layer) is generally 1 to 80 mass%, preferably 5 to 50 mass%, more preferably 10 to 40 mass%.

The solvent used to prepare a coating solution containing polysilazane is preferably an organic solvent free of water and reactive groups (such as hydroxyl group and amino group) inactive to polysilazane, more preferably an aprotic solvent.

Examples of the solvent that can be used to prepare a coating solution containing polysilazane include aprotic solvents, such as aliphatic hydrocarbons, aromatic hydrocarbons, and halogenated hydrocarbons; esters, such as ethyl acetate and butyl acetate; ketones, such as acetone and methyl ethyl ketone; and ethers, such as tetrahydrofuran, dibutyl ether, and monoalkylene and polyalkylene glycol dialkyl ethers (diglyme). These solvents may be used alone or in combination.

The coating solution containing polysilazane may contain optional additives. Examples of such additives include cellulose ethers; cellulose esters, such as ethyl cellulose, nitrocellulose, cellulose acetate, and cellulose acetobutyrate; natural resins, such as rubber and rosin; synthetic resins, such as polymer resins; and condensation resins, such as aminoplast. Specific examples include urea resins, melamine-formaldehyde resins, alkyd resins, acrylic resins, polyesters, modified polysters, epoxide, polyisocyanate, blocked polyisocyanate, and polysiloxane.

Such a coating solution containing polysilazane can form a dense glassy gas barrier layer without cracks and micropores, which serves as a superior barrier against gases. The gas barrier layer preferably has a thickness of 20 nm to 2 µm.

(Modification of Polysilazane and Irradiation of Polysilazane with Vacuum Ultraviolet Rays)

According to the present invention, at least part of the polysilazane in a coating film (polysilazane layer) formed with a coating solution containing polysilazane is subjected to silica conversion by a predetermined modification treatment to obtain $SiO_xN_y$, where x is preferably within the range of 1.2 to 2.0.

According to the present invention, a modification treatment, i.e., the irradiation of a coating film (polysilazane layer) with ultraviolet rays having a wavelength of 400 nm or less, preferably with vacuum ultraviolet rays (VUV) having a wavelength of less than 180 nm, breaks the Si-H and N-H bonds and forms Si-O bonds, which results in the conversion of the coating film to a ceramic, such as silica, to form a gas barrier layer.

The degree of conversion can be semi-quantitatively evaluated through IR spectroscopy by the following expression:

```
SiO/SiN ratio = post-conversion SiO absorbance / post-conversion SiN absorbance
```

where SiO has a characteristic absorption of the absorbance of approximately 1160 cm$^{-1}$ and SiN has a characteristic absorption of the absorbance of approximately 840 cm$^{-1}$. As the SiO/SiN ratio increases, a conversion to a ceramic having a silica composition proceeds.

According to the present invention, the SiO/SiN ratio, which serves as an index for the degree of ceramic conversion, is preferably 0.3 or more, more preferably 0.5 or more. A SiO/SiN ratio below 0.3 is not preferred because satisfactory gas barrier properties may not be achieved.

The silica conversion ratio (i.e., x in SiO$_x$) can be measured by XPS, for example. The composition of a metal oxide (SiO$_x$) in the gas barrier layer can be measured by measuring the atomic composition ratio with an XPS surface analyzer. The atomic composition ratio can also be determined by measuring a cross-section of the gas barrier layer with an XPS surface analyzer. An example of the XPS surface analyzer is ESCA3200 manufactured by Shimadzu Co.

Thus, in a process of manufacturing a gas barrier film according to the present invention, a coating film is formed by applying a coating solution containing polysilazane to at least one of the sides of a substrate and performing a modification treatment to the dried coating film free of water (solvent) by irradiation with ultraviolet rays having a wavelength of 400 nm or less, to form a gas barrier layer. At least one component of the ultraviolet rays having a wavelength of 400 nm or less is preferably a vacuum ultraviolet rays (VUV) having a wavelength of less than 180 nm.

The ozone and active oxygen atoms generated by ultraviolet rays (synonymous to ultraviolet light) have high oxidizability and contribute to the formation of a highly dense and insulating silicon oxide or silicon oxynitride film at a low temperature. The ultraviolet irradiation excites and activates O$_2$ and H$_2$O, which contribute to the conversion to ceramic; ultraviolet absorbers; and polysilazane. The conversion to ceramic of the excited polysilazane is promoted to form a dense ceramic film. The ultraviolet irradiation is effective any time after the formation of the coating film.

(Protective Layer)

A protective layer (protective layer containing organosilicon) can be formed with polysiloxane polymer, which is formed from organosilicon compound, or with organic-inorganic hybrid polymer. The protective layer is composed of material containing a siloxane bond.

According to the present invention, a protective layer can be formed on a gas barrier layer or other layers through a process of forming a modified layer composed of organosilicon compounds. In this process, a coating solution containing an organosilicon compound is applied on a gas barrier layer by wet application and is dried, and the dried coating film is irradiated with ultraviolet light to form a modified layer of an organosilicon compound, which serves as a protective layer.

The protective layer according to the present invention is formed of a coating solution mainly composed of an organosilicon compound and an organic solvent.

(Polysiloxanes)

Examples of polysiloxanes that can be used for the protective layer include: (A) high-strength organopolysiloxanes prepared through the hydrolysis of chlorosilane or alkoxysilane by a sol-gel reaction and polycondensation of the hydrolysate; and (B) organopolysiloxanes prepared by cross-linking reactive silicones having superior water and/or oil repellency.

An organopolysiloxane of (A) is preferably a hydrolytic condensation or a hydrolytic co-condensation of at least one type of silicon compound represented by the general formula Y$_n$SiX$_{(4-n)}$, where Y represents an alkyl group, a fluoroalkyl group, a vinyl group, an amino group, a phenyl group, or an epoxy group; X represents an alkoxyl group, an acetyl group, or a halogen group, and n represents an integer from 0 to 3. The carbon number of the group represented by Y is preferably 1 to 20, and the alkoxy group represented by X is preferably a methoxy, ethoxy, propoxy, or butoxy group.

Specific examples include methyltrichlorosilane, methyltribromosilane, methyltrimethoxysilane, methyltriethoxysilane, methyltriisopropoxysilane, and methyltri-t-butoxysilane; ethyltrichlorosilane, ethyltribromosilane, ethyltrimethoxysilane, ethyltriethoxysilane, ethyltriisopropoxysilane, and ethyltri-t-butoxysilane; n-propyltrichlorosilane, n-propyltribromosilane, n-propyltrimethoxysilane, n-propyltriethoxysilane, n-propyltriisopropoxysilane, and n-propyltri-t-butoxysilane; n-hexyltrichlorosilane, n-hexyltribromosilane, n-hexyltrimethoxysilane, n-hexyltriethoxysilane, n-hexyltriisopropoxysilane, and n-hexyltri-t-butoxysilane; n-decyltrichlorosilane, n-decyltribromosilane, n-decyltrimethoxysilane, n-decyltriethoxysilane, n-decyltriisopropoxysilane, and n-decyltri-t-butoxysilane; n-octadecyltrichlorosilane, n-octadecyltribromosilane, n-octadecyltrimethoxysilane, n-octadecyltriethoxysilane, n-octadecyltriisopropoxysilane, and n-octadecyltri-t-butoxysilane; phenyltrichlorosilane, phynyltribromosilane, phynyltrimethoxysilane, phynyltriethoxysilane, phynyltriisopropoxysilane, and phynyltri-t-butoxysilane; tetrachlorosilane, tetrabromosilane, tetramethoxysilane, tetraethoxysilane, tetrabutoxysilane, and dimethoxydiethoxysilane; dimethyldichlorosilane, dimethyldibromosilane, dimethyldimethoxysilane, and dimethyldiethoxysilan; diphenyldichlorosilane, diphenyldibromosilane, diphenyldimethoxysilane, and diphenyldiethoxysilane; phenylmethyldichlorosilane, phenylmethyldibromosilane, phenylmethyldimethoxysilane, and phenylmethyldiethoxysilane; trichlorohydrosilane, tribromohydrosilane, trimethoxyhydrosilane, triethoxyhydrosilane, triisopropoxyhydrosilane, and tri-t-butoxyhydrosilane; vinyltrichlorosilane, vinyltribromosilane, vinyltrimethoxysilane, vinyltriethoxysilane, vinyltriisopropoxysilane, and vinyltri-t-butoxysilane; trifluoropropyltrichlorosilane, trifluoropropyltribromosilane, trifluoropropyltrimethoxysilane, trifluoropropyltriethoxysilane, trifluoropropyltriisopropoxysilane, and trifluoropropyltri-t-butoxysilane; γ-glycidoxypropylmethyldimethoxysilane, γ-glycidoxypropylmethyldiethoxysilane, γ-glycidoxypropyltrimethoxysilane, γ-glycidoxypropyltriethoxysilane, γ-glycidoxypropyltriisopropoxysilane, and γ-glycidoxypropyltri-t-butoxysilane; γ-methacryloxypropylmethyldimethoxysilane, γ-methacryloxypropylmethyldiethoxysilane, γ-methacryloxypropyltrimethoxysilane, γ-methacryloxypropyltriethoxysilane, γ-methacryloxypropyltriisopropoxysilane, and γ-methacryloxypropyltri-t-butoxysilane; γ-aminopropylmethyldimethoxysilane, γ-aminopropylmethyldiethoxysilane, γ-aminopropyltrimethoxysilane, γ-aminopropyltriethoxysilane, γ-aminopropyltriisopropoxysilane, and γ-aminopropyltri-t-butoxysilane; γ-mercaptopropylmethyldimethoxysilane, γ-mercaptopropylmethyldiethoxysilane, γ-mercaptopropyltrimethoxysilane, γ-mercaptopropyltriethoxysilane, γ-mercaptopropyltriisopropoxysilane, and γ-mercaptopropyltri-t-butoxysilane; β-(3,4-epoxycyclohexyl)ethyltrimethoxysilane and β-(3,4-epoxycyclohexyl)ethyltriethoxysilane; partial hydrolyzates thereof; and mixtures thereof.

Polysiloxanes containing fluoroalkyl groups are preferred. Specific examples include the hydrolytic condensates or hydrolytic co-condensates of at least one of the following fluoroalkylsilanes. In general, any polysiloxane known as a fluorinated silane coupling agent may be used.

Examples of polysiloxane containing fluoroalkyl groups that can be used as a binder include $CF_3(CF_2)_3CH_2CH_2Si(OCH_3)_3$; $CF_3(CF_2)_5CH_2CH_2Si(OCH_3)_3$; $CF_3(CF_2)_7CH_2CH_2Si(OCH_3)_3$; $CF_3(CF_2)_9CH_2CH_2Si(OCH_3)_3$; $(CF_3)_2CF(CF_2)_4CH_2CH_2Si(OCH_3)_3$; $(CF_3)_2CF(CF_2)_6CH_2CH_2Si(OCH_3)_3$; $(CF_3)_2CF(CF_2)_8CH_2CH_2Si(OCH_3)_3$; $CF_3(C_6H_4)C_2H_4Si(OCH_3)_3$; $CF_3(CF_2)_3(C_6H_4)C_2H_4Si(OCH_3)_3$; $CF_3(CF_2)_5(C_6H_4)C_2H_4Si(OCH_3)_3$; $CF_3(CF_2)_7(C_6H_4)C_2H_4Si(OCH_3)_3$; $CF_3(CF_2)_3CH_2CH_2SiCH_3(OCH_3)_2$; $CF_3(CF_2)_5CH_2CH_2SiCH_3(OCH_3)_2$; $CF_3(CF_2)_7CH_2CH_2SiCH_3(OCH_3)_2$; $CF_3(CF_2)_9CH_2CH_2SiCH_3(OCH_3)_2$; $(CF_3)_2CF(CF_2)_4CH_2CH_2SiCH_3(OCH_3)_2$; $(CF_3)_2CF(CF_2)_6CH_2CH_2SiCH_3(OCH_3)_2$; $(CF_3)_2CF(CF_2)_8CH_2CH_2SiCH_3(OCH_3)_2$; $CF_3(C_6H_4)C_2H_4SiCH_3(OCH_3)_2$; $CF_3(CF_2)_3(C_6H_4)C_2H_4SiCH_3(OCH_3)_2$; $CF_3(CF_2)_5(C_6H_4)C_2H_4SiCH_3(OCH_3)_2$; $CF_3(CF_2)_7(C_6H_4)C_2H_4SiCH_3(OCH_3)_2$; $CF_3(CF_2)_3CH_2CH_2Si(OCH_2CH_3)_3$; $CF_3(CF_2)_5CH_2CH_2Si(OCH_2CH_3)_3$; $CF_3(CF_2)_7CH_2CH_2Si(OCH_2CH_3)_3$; $CF_3(CF_2)_9CH_2CH_2Si(OCH_2CH_3)_3$; and $CF_3(CF_2)_7SO_2N(C_2H_5)C_2H_4CH_2Si(OCH_3)_3$.

The organopolysiloxane (B) is a compound having a skeleton represented by the general formula (4):

$$-(SiR^1R^2-O)_n- \qquad (4)$$

where n represents an integer of 2 or more, and $R^1$ and $R^2$ each represent one of a substituted or unsubstituted alkyl group, alkenyl group, aryl group, and cyanoalkyl group having a carbon number of 1 to 10. The molar ratio of vinyl, phenyl, and phenyl halide to the total organopolysiloxane is 40% or less. Each of $R^1$ and $R^2$ is preferably methyl group because the surface energy is minimized. The molar ratio of the methyl group is preferably 60% or more. Each molecular chain preferably has at least one reactive group, such as a hydroxyl group, at the chain ends or side chains.

The organopolysiloxanes described above may be mixed with a stable organosilicon compound that does not cross-link with dimethylpolysiloxane.

The protective layer may contain a surfactant. Specific examples of the surfactant include fluorine or silicone non-ionic surfactants, such as NIKKOL BL, BC, BO, and BB series, which are hydrocarbons, made by Nikko Chemicals Co. , Ltd.; ZONYL FSN and FSO made by Du Pont K.K.; Surflon S-141 and 145 made by Asahi Glass Co., Ltd.; Megaface F-141 and 144 made by DIC Co.; Ftergent F-200 and F251 made by Neos Co., Ltd.; Unidyne DS-401 and 402 manufacture by Daikin Industries, Ltd.; and Flourad FC-170 and 176 made by 3M Company. Alternatively, cationic surfactants, anionic surfactants, or amphoteric surfactants may be used.

The protective layer may contain components, such as oligomers and polymers of polyvinyl alcohols, unsaturated polyesters, acrylic resins, polyethylene, diallyl phthalate, ethylene propylene diene monomers, epoxy resins, phenolic resins, polyurethane, melamine resins, polycarbonates, polyvinyl chloride, polyamides, polyimides, styrene-butadiene rubber, polychloroprene, polypropylene, polybutylene, polystyrene, polyvinyl acetate, polyesters, polybutadiene, polybenzimidazole, polyacrylonitrile, epichlorohydrin, polysulfide, and polyisoprene, other than the surfactants listed above.

As described above, a protective layer can be formed by application of a coating solution prepared by dispersing the components listed above and optional additive in a solvent on a substrate (gas barrier layer). Preferred solvents are alcoholic organic solvents, such as ethanol and 2-propanol. The coating solution may be applied by a known application procedure, such as spin coating, spray coating, dip coating, roll coating, or bead coating.

After applying the coating solution and forming a coating film, the coating film from which water (solvent) has been removed is modified through irradiation with ultraviolet rays having a wavelength of 300 nm or less, to form a protective layer. A preferred modification treatment involves the irradiation of vacuum ultraviolet rays (VUV) having a wavelength of less than 180 nm.

The thickness of the protective layer is preferably within the range of 0.1 to 5 $\mu$m, more preferably 0.3 to 1.5 $\mu$m. A protective layer having a thickness of less than 0.1 $\mu$m achieves sufficient adhesiveness to the gas barrier layer. A protective layer having a thickness of 5 $\mu$m or less has fewer cracks.

(Organic-inorganic Hybrid Polymers)

The protective layer can be composed of organic-inorganic hybrid polymers. The protective layer composed of organic-inorganic hybrid polymers has excellent adhesiveness to the gas barrier layer.

The organic-inorganic hybrid polymers include at least one polymer selected from the group consisting of organosilanes, hydrolyzates of organosilanes, and condensates of organosilanes, and polymers prepared through the hydrolysis and co-condensation of organic polymers containing silyl groups.

A preferred organosilane (hereinafter referred to as compound OS) is represented by the general formula (5):

$$(R^1)_n Si(OR^2)_{4-n} \qquad (5)$$

where $R^1$ represents an organic group having a carbon number of 1 to 8, $R^2$ represents an alkyl group having a carbon number of 1 to 5 or an acyl group having a carbon number of 1 to 6, and n represents an integer of 0 to 2.

Examples of the groups represented by $R^1$ include alkyl groups, such as methyl group, ethyl group, propyl group, butyl group, hexyl group, heptyl group, octyl group, and 2-ethylhexyl group; acyl groups, such as acetyl group, propionyl group, butyryl group, and benzoyl group; vinyl group; allyl groups; cyclohexyl group; and phenyl group. If there are two $R^1$s, they may be the same group or different groups.

Examples of the groups represented by $R^2$ include alkyl groups having a carbon number of 1 to 5, such as a methyl group, ethyl group, propyl group, butyl group, and pentyl group; and acyl groups having a carbon number of 1 to 6, such as an acetyl group, propionyl group, and butyryl group. If there are two $R^2$s, they may be the same group or different groups.

Specific examples of compounds OS include tetraalkoxysilanes (n=0), such as tetramethoxysilane, tetraethoxysilane, tetra-n-propoxysilane, tetra-i-propoxysilane, and tetra-n-butoxysilane; trialkoxysilanes (n=1), such as methyltrimethoxysilane, methyltriethoxysilane, ethyltrimethoxysilane, ethyltriethoxysilane, n-propyltrimethoxysilane, n-propyltriethoxysilane, i-propyltrimethoxysilane, i-propyltriethoxysilane, n-butyltrimethoxysilane, n-butyltriethoxysilane, n-pentyltrimethoxysilane, n-hexyltrimethoxysilane, n-heptyltrimethoxysilane, and n-octyltrimethoxysilane; and dialkoxysilanes (n=2), such as dimethyldimethoxysilane, dimethyldiethoxysilane, diethyldimethoxysilane, diethyldiethoxysilane, di-n-propyldimethoxysilane, di-n-propyldiethoxysilane, di-i-propyldimethoxysilane, di-i-propyldiethoxysilane, di-n-butyldimethoxysilane, di-n-butyldiethoxysilane, di-n-pentyldimethoxysilane, di-n-pentyldiethoxysilane, di-n-hexyldimethoxysilane, di-n-hexyldiethoxysilane, di-n-heptyldimethoxysilane, di-n-heptyldiethoxysilane, di-n-octyldimethoxysilane, and di-n-octyldiethoxysilane.

The compounds OS may be used alone or in combination. The compounds OS may be a hydrolyzate or a condensate.

An organic polymer containing silyl groups has silicon atoms bonded to a hydrolyzable group and/or a hydroxyl group on the ends and/or side chains.

Examples of organic polymers containing silyl groups include acrylic resins containing silyl groups, vinyl resins containing silyl groups, urethane resins containing silyl groups, epoxy resins containing silyl groups, polyester resins containing specific silyl groups, and fluorine resins containing specific silyl groups.

A preferred silyl group is represented by the general formula (6):

$$-SiX_m(R^3)_{3-m} \qquad (6)$$

where X represents a hydrolyzable group or a hydroxyl group; $R^3$ represents one of a hydrogen atom, an alkyl group having a carbon number of 1 to 10, and an aralkyl group having a carbon number of 1 to 10; and m represents an integer of 1 to 3. Examples of hydrolyzable groups include a halogen atom, an alkoxyl group, an acetoxy group, a phenoxy group, a thioalkoxyl group, and an amino group.

Such organic-inorganic hybrid polymers are prepared by adding a hydrolysis-condensation catalyst and water to a compound OS and an organic polymer having silyl group and then subjecting the compound OS and the organic polymer having silyl group to hydrolysis and co-condensation.

Examples of the hydrolysis-condensation catalyst include acidic compounds, alkaline compounds, salt compounds, amine compounds, organic metal compounds, and partial hydrolyzates thereof.

Examples of the acidic compounds include acetic acid, hydrochloric acid, sulfuric acid, and phosphoric acid.

Examples of the alkaline compounds include sodium hydroxide and potassium hydroxide.

Examples of the salt compounds include alkali metal salts.

Examples of the amine compounds include 3-aminopropyltrimethoxysilane, 3-aminopropyltriethoxysilane, and 3-(2-aminoethyl)-aminopropyltrimethoxysilane.

Examples of the organic metal compounds include organic tetravalent tin compounds.

The organic-inorganic hybrid polymer of the protective layer may be thermally cross-linked with a curing agent to increase the hardness of the protective layer to a certain level. The thermal cross-link reduces the tackiness, the thermal expansion and contraction of the protective layer, and the cracking of the protective layer. Examples of the curing agent include tin compounds, aluminum compounds, and zirconium compounds (zirconia). The amount of the curing agent is preferably 1 to 20 parts by mass relative to 100 parts by mass of organic-inorganic hybrid polymers.

The protective layer may contain an inorganic filler. Examples of the inorganic filler include silica, alumina, titanium oxide not functioning as a photocatalyst, zirconia, zinc oxide, and cerium oxide. Silica is preferred to maintain hydrophilicity. The amount of the inorganic filler is preferably 1 to 50 parts by mass relative to 100 parts by mass of the organic-inorganic hybrid polymer.

The protective layer may contain resins other than organic-inorganic hybrid polymers and known additives without departing from the obj ect and advantageous effect of the present invention.

As described above, a protective layer can be formed by preparing a coating solution by dispersing the components listed above and optional additive in a solvent and applying the coating solution on a substrate (gas barrier layer). Preferred solvents are alcoholic organic solvent, such as ethanol and 2-propanol. The coating solution may be applied by a known application procedure, such as spin coating, spray coating, dip coating, roll coating, or bead coating.

After applying the coating solution and forming a coating film, the coating film from which water is removed is modified through irradiation with ultraviolet rays having a wavelength of 300 nm or less, to form a protective layer. A preferred modification treatment involves the irradiation of vacuum ultraviolet rays (VUV) having a wavelength of less than 180 nm.

The thickness of the protective layer is preferably within the range of 0.1 to 5 $\mu$m, more preferably 0.3 to 1.5 $\mu$m. A protective layer having a thickness of less than 0.1 $\mu$m achieves sufficient adhesiveness to the gas barrier layer. A protective layer having a thickness of 5 $\mu$m or less has fewer cracks.

(Density of Film)

The density of a gas barrier layer containing silicon oxynitride ($SiO_xN_y$) is preferably within the range of 1.5 to 2.6 g/cm$^3$ (inclusive). A gas barrier layer having a density outside this range is not preferred due to an alteration in composition of the gas barrier layer, a reduction in the compactness of the film, which leads to inferior gas barrier properties, and oxidative degradation of the film caused by moisture.

The density of the protective layer is preferably 0.5 g/cm$^3$ or more and 1.5 g/cm$^3$ or less. A protective layer having a density of less than 0.5 g/cm$^3$ has inferior gas barrier properties, whereas a protective layer having a density exceeding 1.5 g/cm$^3$ readily cracks.

In the gas barrier film according to the present invention, the ratio of the density of the protective layer to the density of the gas barrier layer is preferably 0.2 or more and 0.75 or less.

The composition of the gas barrier layer (silicon oxynitride) can be determined through photoelectron spectroscopy (XPS). As a specific apparatus, ESCA3200 manufactured by Shimadzu Co. may be used. The film density can be measured through an X-ray reflectivitymethod. As a specific measuring apparatus, ATX-G manufactured by Rigaku Co. may be used.

(Use of Gas Barrier Film)

If the gas barrier film according to the present invention is to be used as a substrate of a display apparatus, the layers required for the relevant display scheme can be disposed on either side of the gas barrier film. Such layers maybe disposed between the substrate and a gas barrier layer; thus, the gas barrier film according to the present invention also includes a gas barrier film having a layer(s) to achieve the display function that is disposed between the substrate and a thin layer (gas barrier layer or protective layer).

The gas barrier films according to the present invention may be applied to various displays; typical displays are liquid crystal displays and organic EL displays.

A liquid crystal display includes two transparent electrodes disposed on inner faces of two opposite substrates and includes alignment layers on the electrodes to sandwich liquid crystals, and the periphery is sealed. Usually, a color filter is provided for display of color images. The gas barrier film according to the present invention may be disposed on the outer side of the substrates of such a liquid crystal display or may be used in place of the substrate. Replacing the two substrates with the gas barrier films according to the present invention achieves a fully flexible display.

An organic EL display includes two transparent electrodes disposed on inner faces of two opposite substrates and an organic EL element layer sandwiched between the two substrates, the organic EL element layer composed of a composite layer of sublayers having different functions of, for example, electron and positive hole injection and transportation, and light emission; and the periphery is sealed. The organic EL display may also include a color filter for the display of color images and/or other components. Similarly to the liquid crystal display, gas barrier film according to the present invention may be disposed on the outer side of the substrates or may be disposed in place of the substrates. Replacing the two substrates with the gas barrier films according to the present invention achieves a fully flexible display. Organic EL displays include fluorescent material (light-emitting layer) that is unstable and highly vulnerable to moisture. For this reason, superior water vapor barrier characteristic is required for organic EL display products, and the use of gas barrier films is very effective.

Examples

Specific examples of the gas barrier film according to the present invention will now be described in detail. The present invention, however, should not be limited to these examples. The term "part" and the sign "%" used in the examples refer to "part by mass" and "mass%," respectively, unless otherwise specified.

[Example 1]

(Production of Gas Barrier Films 1 to 17)

<Formation of Gas Barrier Layer>

A polyethylene naphthalate resin film ("Teonex" manufactured by Teijin DuPont Films Japan Ltd.) was used as a substrate, the film having a glass-transition temperature of 155°C, a coefficient of thermal expansion of 8 ppm, a coefficient of hygroscopic expansion of 0.5 ppm, and a thickness of 200 $\mu$m.

A solution of siloxane UV-curable polymer (3% of "X-12-2400" manufacture by Shin-Etsu Chemical Co., Ltd. in isopropyl alcohol) was applied on one side of the substrate by gravure printing, and the solution was removed by hot air at a temperature of 120°C and then the polymer was cured with ultraviolet rays, to form a primer layer having a thickness of 0.1 $\mu$m.

A polysilazane gas barrier layer was formed on the primer layer in accordance with the procedures described below.

<<Preparation of Coating Solution Containing Polysilazane>>

A solution of 10-mass% perhydropolysilazane (uncatalyzed Aquamica NN120-10 manufactured by AZ Electronic Materials) in dibutyl ether was prepared as a coating solution containing polysilazane.

The coating solution containing polysilazane was applied to the primer layer with a wireless bar into an average dry thickness of 150 nm, and the coating was dried for one minute in an atmosphere at a temperature of 85°C and a humidity of 55%RH and then was dehumidified for 10 minutes in an atmosphere at a temperature of 25°C and a humidity of 10%RH (dew-point temperature: -8°C), to form a polysilazane layer.

A silica conversion treatment (modification treatment) was then performed to the polysilazane layer at a dew-point temperature of -8°C or less in accordance with the procedures described below.

The substrate with the polysilazane layer was fixed onto a stage of an ultraviolet irradiation apparatus, and the modification treatment was performed to the substrate (polysilazane layer) under the conditions listed below, to form a gas barrier layer. The density of the gas barrier layer and the element ratio ($x/(x+y)$) in the modified layer (silicon oxynitride ($SiO_xN_y$) layer) were varied by adjusting the heating temperature and the excimer irradiation time (see Table 1).

<<Ultraviolet Irradiation Treatment>>

Apparatus: Excimer irradiation apparatus MECL-M-1-200 manufactured by M. D. COM. Inc.
Irradiation wavelength: 172 nm
Gas in Lamp: xenon
Light intensity of excimer lamp: 130 mW/cm$^2$ (172 nm)
Distance between sample and light source: 1 mm
Oxygen concentration in apparatus: 1.0%
Heating temperature of stage: heating temperatures (°C) listed in Table 1

Irradiation time of excimer lamp: irradiation times (second) listed in Table 1

<Formation of Protective Layer>

A protective layer was formed on the gas barrier layer in accordance with the procedures described below.

Silica sol (30 parts by weight, Glasca HPC7002 manufactured by JSR Co.) and alkylalkoxysilane (10 parts by weight, Glasca HPC402H manufactured by JSR Co.) were mixed with stirring for 30 minutes to prepare a coating solution for a protective layer.

The coating solution for the protective layer was applied onto the gas barrier layer with a spin coater. The coating solution was applied so as to form a protective layer having a thickness of 650 nm. The coating layer was heated at 100°C for 10 minutes to be dried and then receives a modification treatment with ultraviolet irradiation under the conditions listed below, to form a protective layer. The density of the protective layer and the element ratio (Si/C) in the protective layer were varied by adjusting the heating temperature and the excimer irradiation time (listed in Table 1).

«Ultraviolet Irradiation Treatment>>

Apparatus: Excimer irradiation apparatus MECL-M-1-200 manufactured by M. D. COM. Inc.
Irradiation wavelength: 172 nm
Gas in Lamp: xenon
Light intensity of excimer lamp: 130 mW/cm$^2$ (172 nm)
Distance between sample and light source: 1 mm
Oxygen concentration in apparatus: 1.0%
Heating temperature of stage: heating temperatures (°C) listed in Table 1
Irradiation time of excimer lamp: irradiation times (second) listed in Table 1

The gas barrier films 1 to 17 listed in Table 1 were formed as described above.

The gas barrier film 17 was irradiated with ultraviolet rays having a wavelength of 308 nm at 300 mJ/cm$^2$ and 50°C from an eximer laser light source XeCl.

The element ratio (x/ (x+y)) in the gas barrier layers and the element ratio (Si/C) in the protective layers of the gas barrier films 1 to 17 were measured by XPS with ESCALAB-200R manufacture by VG Scientifics. The measurement results are listed in Table 1.

[Example 2]

(Production of Gas Barrier Films 22 to 26)

The gas barrier films 22 to 26 listed in Table 2 were formed as in Example 1, except that the substrate (polyethylene naphthalate (PEN)) of the gas barrier film 7 in Example 1 was replaced with material described below.

A polycarbonate (PC) film ("Bayfol LP202" manufactured by Bayer AG)was used as a substrate "2-1" of the gas barrier film 22, the film having a glass-transition temperature of 220°C, a coefficient of thermal expansion of 75 ppm, a coefficient of hygroscopic expansion of 0.23 ppm, and a thickness of 200 μm.

A polyether sulfone (PES) resin film (manufactured by Sumitomo Bakelite Co., Ltd.) was used as a substrate "2-2" of the gas barrier film 23, the film having a glass-transition temperature of 230°C, a coefficient of thermal expansion of 45 ppm, a coefficient of hygroscopic expansion of 4.5 ppm, and a thickness of 200 μm.

A norbornene resin film ("Arton" manufactured by JSR Co.) was used as a substrate "2-3" of the gas barrier film 24, the film having a glass-transition temperature of 183°C, a coefficient of thermal expansion of 70 ppm, a coefficient of hygroscopic expansion of 0.67 ppm, and a thickness of 200 μm.

A cycloolefin polymer film ("Zeonor" manufactured by Zeon Co.) was used as a substrate "2-4" of the gas barrier film 25, the film having a glass-transition temperature of 176°C, a coefficient of thermal expansion of 78 ppm, a coefficient of hygroscopic expansion of 0.35 ppm, and a thickness of 200 μm.

A polyethylene terephthalate (PET) resin film (manufactured by Teijin Ltd.) was used as a substrate "2-5" of the gas barrier film 26, the film having a glass-transition temperature of 120°C, a coefficient of thermal expansion of 5 ppm, a coefficient of hygroscopic expansion of 0.5 ppm, and a thickness of 200 μm.

[Example 3]

(Production of Gas Barrier Films 31 to 36)

The process of producing gas barrier films according to Example 1 was modified such that the irradiation time of the excimer lamp during the formation of a gas barrier layer was adjusted to those listed in Table 3 and the ultraviolet irradiation treatment during the formation of a protective layer was performed under the three conditions listed in Tables 3, i.e., "1: the same irradiation conditions as Example 1," "2: the irradiation condition described below," and "without irradiation, " to form gas barrier films 31 to 36 listed in Table 3. The heating temperature of the stage during the formation of a protective layer was 57°C and the irradiation time of the excimer lamp was three seconds.

«Ultraviolet Irradiation Treatment "2: Irradiation Conditions"»

The irradiation wavelength and the light intensity of the excimer lamp of the ultraviolet irradiation treatment in Example 1 were changed in accordance with the conditions below.

Irradiation wavelength: 222 nm
Light intensity of excimer lamp: 800 mW/cm$^2$ (222 nm)

[Example 4]

(Production of Gas Barrier Films 42 to 48)

Gas barrier films 42 to 48 having the layer configurations listed in Table 4 were formed on the basis of the layer configuration "substrate / primer layer / A (gas barrier layer) / B (protective layer)" of the gas barrier film 7 according to Example 1.
In Example 4, the ratio of the density of the protective layer to the density of the gas barrier layer was determined by calculating the ratio of the density of the protective layer (B) disposed on a gas barrier layer (A) to the density of the gas barrier layer (A).
The gas barrier film samples 1 to 17, 22 to 26, 31 to 36, and 42 to 48 formed as described above were evaluated as described below to measure the element ratio and determine the water vapor barrier characteristic (water vapor transmission rate (WVTR)), bendability, and transparency.

(Measurement of Element Ratio)

The element ratio of the gas barrier layer of each gas barrier film was measured by XPS.
In detail, ESCALAB-200R manufactured by VG Scientifics with an Mg X-ray anode and a power of 600 W (accelerating voltage : 15 kV, emission current: 40 mA) was used to determine x and y in $SiO_xN_y$ to obtain the element ratio. The element ratio (Si/C) of each protective layer was also obtained in the same way.
The measurement results are listed in Tables 1 to 3.

(Water Vapor Barrier Characteristic (Water Vapor Transmission Rate (WVTR))

The amount of permeated water (water vapor transmission rate) of each gas barrier film was measured as described below to evaluate the water vapor barrier characteristic.
Any method may be employed for measuring the water vapor transmission rate of the gas barrier film according to the present invention. A method using Ca was employed in this example to measure the water vapor transmission rate.

<Apparatus Used>

Deposition apparatus: vacuum deposition apparatus JEE-400 manufactured by JEOL, Ltd.
Thermo-hygrostat oven: Yamato Humidic Chamber IG47M <Evaluated Material>
Metal corroding by reaction with water: calcium (granules)
Metal impermeable to water vapor: aluminum (granules having a diameter of 3 to 5 mm)

<Preparation of Evaluation Cell for Water Vapor Barrier Characteristic>

The vacuum deposition apparatus (vacuum deposition apparatus JEE-400 manufactured by JEOL, Ltd.) was used to deposit metal calcium with a mask at the area other than the deposition target portions (nine 12×12-mm areas) on the surface of a gas barrier or protective layer sample. The mask was then removed while the vacuum was being maintained, and aluminum was deposited from another metal deposition source onto the entire surface of the layer. After the aluminum sealing, the vacuum was released and a dry nitrogen atmosphere was quickly introduced, a 0.2-mm thick quartz glass was bonded to the aluminum deposited surface with UV-curable resin for sealing (manufactured by Nagase Chemtex Co.), and the resin was irradiated with ultraviolet rays to cure and bond the resin for full sealing, to form a cell for evaluation of water vapor barrier characteristic.

The resulting cell for evaluation was stored in the thermo-hygrostat oven under a high temperature of 60°C and a high humidity of 90%RH, and the amount of water permeating into the cell was calculated from the amount of corrosion of the metal calcium in accordance with the procedures described in Japanese Patent Application Laid-Open Publication No. 2005-283561.

To confirm that water vapor permeates only through the barrier film, a cell using a comparative sample, instead of the barrier film sample, composed of a 0.2-mm thick quartz glass plate on which metal calcium was deposited was stored at a high temperature of 60°C and a high humidity of 90%RH. Thus, it was confirmed that the corrosion of the metal calcium did not occur after 1000 hours.

The amount of permeated water (water vapor transmission rate) of each gas barrier film, which was measured in this way, was evaluated. The measurement and evaluation results are listed in Tables 1 to 4.

(Bendability)

Each gas barrier film was repeatedly bent 100 times at the angle of 180 degrees with a radius of curvature of 10 mm, the amount of permeated water (water vapor transmission rate) was measured in the same manner as that described above, and the level of deterioration resistance was calculated by the following expression on the basis of the change in amount of permeated water before and after the bending test, to evaluate the bending resistance (bendability) in accordance with the criteria described below. The evaluation results are listed in Tables 1 to 4.

$$\text{Level of deterioration resistance = (amount of permeated}$$

$$\text{water after bending test / amount of permeated water before}$$

$$\text{bending test)} \times 100\%$$

5: The level of deterioration resistance is 90% or more.
4: The level of deterioration resistance is 80% or more and less than 90%.
3: The level of deterioration resistance is 60% or more and less than 80%.
2: The level of deterioration resistance is 30% or more and less than 60%.
1: The level of deterioration resistance is less than 30%.

(Transparency)

The visible light transmittance of each gas barrier film was measured with a spectrophotometer V-570 (manufactured by Jasco Co.). The evaluation results are listed in Tables 1 to 4.

[Table 1]

| No. | SUBSTRATE | SiOxNy LAYER (GAS BARRIER LAYER) | | | | | | ORGANIC SILICON LAYER (PROTECTIVE LAYER) | | | | FILM DENSITY RATIO | WVTR (g/m²·24h) | BENDABILITY LEVEL | TRANSPARENCY (%) | REMARKS |
|---|---|---|---|---|---|---|---|---|---|---|---|---|---|---|---|---|
| | | HEATING TEMPERATURE (°C) | IRRADIATION TIME (SECOND) | FILM DENSITY | x | y | x/(x+y) | HEATING TEMPERATURE (°C) | IRRADIATION TIME (SECOND) | FILM DENSITY | ELEMENT RATIO Si/C | | | | | |
| 1 | PEN | 70 | 10 | 2.3 | 0.8 | 0.81 | 0.50 | 57 | 3 | 0.5 | 0.15 | 0.22 | 0.008 | 3 | 91 | PRESENT INVENTION |
| 2 | PEN | 70 | 7 | 2 | 0.65 | 0.9 | 0.42 | 57 | 3 | 0.5 | 0.2 | 0.25 | 0.008 | 3 | 90 | PRESENT INVENTION |
| 3 | PEN | 70 | 6.5 | 1.9 | 0.56 | 0.95 | 0.37 | 57 | 3 | 0.5 | 0.31 | 0.26 | 0.005 | 4 | 92 | PRESENT INVENTION |
| 4 | PEN | 70 | 5 | 1.8 | 0.5 | 1.1 | 0.31 | 57 | 3 | 0.5 | 0.43 | 0.28 | 0.005 | 4 | 92 | PRESENT INVENTION |
| 5 | PEN | 70 | 3 | 1.7 | 1.82 | 0.22 | 0.89 | 57 | 3 | 0.5 | 0.5 | 0.29 | 0.005 | 4 | 92 | PRESENT INVENTION |
| 6 | PEN | 70 | 10 | 2.3 | 0.8 | 0.81 | 0.50 | 70 | 5 | 1 | 0.6 | 0.43 | 0.005 | 4 | 92 | PRESENT INVENTION |
| 7 | PEN | 70 | 7 | 2 | 0.65 | 0.9 | 0.42 | 70 | 5 | 1 | 0.6 | 0.50 | 0.004 | 4 | 92 | PRESENT INVENTION |
| 8 | PEN | 70 | 6.5 | 1.9 | 0.56 | 0.95 | 0.37 | 70 | 5 | 1 | 0.6 | 0.53 | 0.004 | 4 | 92 | PRESENT INVENTION |
| 9 | PEN | 70 | 5 | 1.8 | 0.5 | 1.1 | 0.31 | 70 | 5 | 1 | 0.6 | 0.56 | 0.004 | 4 | 92 | PRESENT INVENTION |
| 10 | PEN | 70 | 3 | 1.7 | 1.82 | 0.22 | 0.89 | 70 | 5 | 1 | 0.6 | 0.59 | 0.004 | 4 | 92 | PRESENT INVENTION |
| 11 | PEN | 70 | 10 | 2.3 | 0.8 | 0.81 | 0.50 | 120 | 10 | 1.5 | 0.6 | 0.65 | 0.004 | 4 | 92 | PRESENT INVENTION |
| 12 | PEN | 70 | 7 | 2 | 0.65 | 0.9 | 0.42 | 120 | 10 | 1.5 | 0.6 | 0.75 | 0.004 | 4 | 92 | PRESENT INVENTION |
| 13 | PEN | 70 | 6.5 | 1.9 | 0.56 | 0.95 | 0.37 | 120 | 10 | 1.5 | 0.6 | 0.79 | 0.1 | 3 | 89 | COMPARATIVE EXAMPLE |
| 14 | PEN | 70 | 5 | 1.8 | 0.5 | 1.1 | 0.31 | 120 | 10 | 1.5 | 0.6 | 0.83 | 0.12 | 2 | 88 | COMPARATIVE EXAMPLE |
| 15 | PEN | 70 | 3 | 1.7 | 1.82 | 0.22 | 0.89 | 120 | 10 | 1.5 | 0.6 | 0.88 | 0.11 | 2 | 88 | COMPARATIVE EXAMPLE |
| 16 | PEN | 70 | 1.5 | 1.51 | 0.61 | 0.15 | 0.81 | 57 | 3 | 0.5 | 0.6 | 0.33 | 0.1 | 2 | 75 | COMPARATIVE EXAMPLE |
| 17 | PEN | 70 | 9 | 1.42 | 0.89 | 0.15 | 0.86 | 57 | 3 | 0.5 | 0.6 | 0.35 | 0.5 | 2 | 69 | COMPARATIVE EXAMPLE |

[Table 2]

| No. | MATERIAL | SUBSTRATE | | | | FILM DENSITY RATIO | WVTR (g/m²·24h) | BENDABILITY LEVEL | TRANSPARENCY (%) | REMARKS |
|---|---|---|---|---|---|---|---|---|---|---|
| | | *1 | *2 | *3 | *4 | | | | | |
| 7 | POLYETHYLENE NAPHTHALATE | 155 | 8 | 0.5 | 200 | 0.50 | 0.004 | 4 | 92 | PRESENT INVENTION |
| 22 | POLYCARBONATE | 220 | 75 | 0.23 | 200 | 0.50 | 0.004 | 4 | 91 | PRESENT INVENTION |
| 23 | POLYETHER SULFONE | 230 | 45 | 4.5 | 200 | 0.50 | 0.005 | 4 | 90 | PRESENT INVENTION |
| 24 | NORBORNENE RESIN | 183 | 70 | 0.67 | 200 | 0.50 | 0.004 | 4 | 92 | PRESENT INVENTION |
| 25 | CYCLOOLEFIN POLYMER | 176 | 78 | 0.35 | 200 | 0.50 | 0.004 | 4 | 92 | PRESENT INVENTION |
| 26 | POLYETHYLENE TEREPHTHALATE | 120 | 5 | 0.5 | 200 | 0.50 | 0.01 | 3 | 90 | PRESENT INVENTION |

*1 GLASS-TRANSITION TEMPERATURE (°C)
*2 COEFFICIENT OF THERMAL EXPANSION (ppm)
*3 COEFFICIENT OF HYGROSCOPIC EXPANSION (ppm)
*4 THICKNESS ($\mu$m)

[Table 3]

| No. | SUBSTRATE | SiO$_x$N$_y$ LAYER (GAS BARRIER LAYER) | | | | | | ORGANIC SILICON LAYER (PROTECTIVE LAYER) | | | | | FILM DENSITY RATIO | WVTR (g/m²·24h) | BENDABILITY LEVEL | TRANSPARENCY (%) | REMARKS |
|---|---|---|---|---|---|---|---|---|---|---|---|---|---|---|---|---|---|
| | | HEATING TEMPERATURE (°C) | IRRADIATION TIME (SECOND) | FILM DENSITY | x | y | x/(x+y) | ULTRAVIOLET LIGHT SOURCE | HEATING TEMPERATURE (°C) | IRRADIATION TIME (SECOND) | FILM DENSITY | ELEMENT RATIO Si/C | | | | | |
| 31 | PEN | 70 | 10 | 1.9 | 0.56 | 0.95 | 0.37 | 1 | 57 | 3 | 0.5 | 0.15 | 0.26 | 0.005 | 4 | 92 | *1 |
| 32 | PEN | 70 | 7 | 1.9 | 0.56 | 0.95 | 0.37 | 2 | 57 | 3 | 0.5 | 0.2 | 0.26 | 0.009 | 3 | 89 | *1 |
| 33 | PEN | 70 | 6.5 | 1.9 | 0.56 | 0.95 | 0.37 | *3 | — | — | 0.5 | 0.31 | 0.26 | 0.1 | 2 | 88 | *2 |
| 34 | PEN | 70 | 5 | 1.9 | 0.56 | 0.95 | 0.37 | 1 | 57 | 3 | 0.5 | 0.43 | 0.26 | 0.005 | 4 | 92 | *1 |
| 35 | PEN | 70 | 3 | 1.9 | 0.56 | 0.95 | 0.37 | 2 | 57 | 3 | 0.5 | 0.5 | 0.26 | 0.009 | 3 | 89 | *1 |
| 36 | PEN | 70 | 10 | 1.9 | 0.56 | 0.95 | 0.37 | *3 | — | — | 1 | 0.6 | 0.53 | 0.11 | 2 | 89 | *2 |

*1 PRESENT INVENTION
*2 COMPARATIVE EXAMPLE
*3 NO IRRADIATION

[Table 4]

| No. | SUBSTRATE | LAYER CONFIGURATION | WVTR (g/m²·24h) | BENDABILITY LEVEL | TRANSPARENCY (%) | REMARKS |
|---|---|---|---|---|---|---|
| 7 | PEN | SUBSTRATE/PRIMER LAYER/A/B | 0.004 | 4 | 92 | *1 |
| 42 | PEN | SUBSTRATE/PRIMER LAYER/A/A/B | 0.001 | 4 | 92 | *1 |
| 43 | PEN | SUBSTRATE/PRIMER LAYER/A/B/A | 0.0005 | 4 | 92 | *1 |
| 44 | PEN | SUBSTRATE/PRIMER LAYER/B/A/B | 0.001 | 4 | 92 | *1 |
| 45 | PEN | SUBSTRATE/PRIMER LAYER/A/B/A/B | 0.0002 | 5 | 92 | *1 |
| 46 | PEN | SUBSTRATE/PRIMER LAYER/A | 0.1 | 2 | 92 | *2 |
| 47 | PEN | SUBSTRATE/PRIMER LAYER/A/A | 0.08 | 1 | 90 | *2 |
| 48 | PEN | SUBSTRATE/PRIMER LAYER/B | 5 | 2 | 93 | *2 |

*1 PRESENT INVENTION

*2 COMPARATIVE EXAMPLE

These evaluation results indicate that a gas barrier film having a configuration according to the present invention has superior gas barrier properties (water vapor barrier characteristic), bending resistance (bendability), and visible light transmittance (transparency), compared to the comparative example.

That is, the gas barrier film including a gas barrier layer disposed over a substrate and a protective layer having received a vacuum ultraviolet irradiation treatment, wherein at least part of the gas barrier layer has a composition $SiO_xN_y$ where the condition $0.1 \leq x/(x+y) \leq 0.9$ is satisfied, and the ratio of the density of the protective layer to the density of the gas barrier layer is 0.2 or more and 0.75 or less, has a superior water vapor barrier characteristic (gas barrier properties), bendability, and transparency.

A gas barrier film according to the present invention has a superior gas barrier properties, transparency, and bendability.

The present invention should not be limited to the embodiments described above and may be appropriately modified within the scope of the invention.

INDUSTRIAL APPLICABILITY

The present invention, which is configured as described above, can be used as gas barrier films.

REFERENCE NUMERALS

1    substrate
2    gas barrier layer
3    protective layer
10   gas barrier film

**Claims**

1. A gas barrier film comprising at least one gas barrier layer and a protective layer over a substrate, the protective layer containing organosilicon and being disposed on the gas barrier layer, wherein
at least part of the gas barrier layer has a composition $SiO_xN_y$ where a condition $0.1 \leq x/(x+y) \leq 0.9$ is satisfied,
the protective layer has received a modification treatment, which is irradiation with ultraviolet light having a wavelength of 300 nm or less, and
a ratio of a density of the protective layer to a density of the gas barrier layer is 0.2 or more and 0.75 or less.

2. The gas barrier film according to Claim 1, wherein the substrate has a thermal expansion rate of 100 ppm/°C or less and a glass-transition temperature of 120°C or more.

3. The gas barrier film according to Claim 1 or 2, wherein the gas barrier layer is formed by performing a modification treatment to a coating film containing polysilazane, the modification treatment being irradiation with ultraviolet light having a wavelength of 400 nm or less.

4. The gas barrier film according to any one of Claims 1 to 3, wherein the protective layer comprises material containing a siloxane bond.

5. The gas barrier film according to any one of Claims 1 to 4, wherein, on each side of one of the gas barrier layer and the protective layer, the other of the gas barrier layer and the protective layer is disposed.

6. The gas barrier film according to any one of Claims 1 to 5, wherein the modification treatment is irradiation with vacuum ultraviolet light having a wavelength of less than 180 nm.

## INTERNATIONAL SEARCH REPORT

| International application No. |
|---|
| PCT/JP2012/081874 |

**A. CLASSIFICATION OF SUBJECT MATTER**
*B32B9/00*(2006.01)i, *B32B27/00*(2006.01)i, *B32B27/16*(2006.01)i

According to International Patent Classification (IPC) or to both national classification and IPC

**B. FIELDS SEARCHED**

Minimum documentation searched (classification system followed by classification symbols)
B32B1/00-43/00

Documentation searched other than minimum documentation to the extent that such documents are included in the fields searched
  Jitsuyo Shinan Koho          1922-1996   Jitsuyo Shinan Toroku Koho   1996-2013
  Kokai Jitsuyo Shinan Koho    1971-2013   Toroku Jitsuyo Shinan Koho   1994-2013

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2011-183773 A  (Konica Minolta Holdings, Inc.),<br>22 September 2011 (22.09.2011),<br>claims; example 1<br>(Family: none) | 1-6 |
| A | WO 2011/007543 A1  (Mitsui Chemicals, Inc.),<br>20 January 2011 (20.01.2011),<br>example 11; table 1<br>& EP 2455220 A1<br>example 11; table 1<br>& CN 102470637 A          & TW 201113152 A<br>& KR 10-2012-0031228 A | 1-6 |

| ☒ | Further documents are listed in the continuation of Box C. | ☐ | See patent family annex. |

\*     Special categories of cited documents:
"A"   document defining the general state of the art which is not considered to be of particular relevance
"E"   earlier application or patent but published on or after the international filing date
"L"   document which may throw doubts on priority claim(s) or which is cited to establish the publication date of another citation or other special reason (as specified)
"O"   document referring to an oral disclosure, use, exhibition or other means
"P"   document published prior to the international filing date but later than the priority date claimed

"T"   later document published after the international filing date or priority date and not in conflict with the application but cited to understand the principle or theory underlying the invention
"X"   document of particular relevance; the claimed invention cannot be considered novel or cannot be considered to involve an inventive step when the document is taken alone
"Y"   document of particular relevance; the claimed invention cannot be considered to involve an inventive step when the document is combined with one or more other such documents, such combination being obvious to a person skilled in the art
"&"   document member of the same patent family

| Date of the actual completion of the international search | Date of mailing of the international search report |
|---|---|
| 08 February, 2013 (08.02.13) | 19 February, 2013 (19.02.13) |

| Name and mailing address of the ISA/<br>  Japanese Patent Office | Authorized officer |
|---|---|
| Facsimile No. | Telephone No. |

Form PCT/ISA/210 (second sheet) (July 2009)

**INTERNATIONAL SEARCH REPORT**

| International application No. |
| --- |
| PCT/JP2012/081874 |

C (Continuation). DOCUMENTS CONSIDERED TO BE RELEVANT

| Category* | Citation of document, with indication, where appropriate, of the relevant passages | Relevant to claim No. |
| --- | --- | --- |
| A | JP 2008-536711 A (Alcan Technology & Management Ltd.), 11 September 2008 (11.09.2008), claims & US 2009/0029056 A1 claims & EP 1888812 A1          & WO 2006/108503 A1 & CA 2603736 A          & AU 2006233551 A & MX 2007011281 A | 1-6 |

Form PCT/ISA/210 (continuation of second sheet) (July 2009)

**EP 2 792 482 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6234186 A
- US 5260095 A
- JP 8269690 A
- EP 0745974 A
- JP 3400324 B
- JP 2002322561 A
- JP 2002361774 A
- JP 5238827 A
- JP 6122852 A
- JP 6240208 A
- JP 6299118 A
- JP 6306329 A
- JP 7196986 A
- JP 2005283561 A